# EUROPEAN PATENT APPLICATION

(11) **EP 4 053 892 A1**
(43) Date of publication of application: **07.09.2022**
(21) Application number: 20883055.4
(22) Date of filing: 28.10.2020
(51) Int. Cl.: H01L 23/02, H01L 33/48, H01S 5/022

(54) **LIGHT-EMITTING ELEMENT MOUNTING PACKAGE AND LIGHT-EMITTING DEVICE**

(30) Priority: 30.10.2019 JP 2019197455
(71) Applicant: Kyocera Corporation, Kyoto-shi Kyoto 612-8501 (JP)
(72) Inventor: MATSUMOTO,Yuhei, Kyoto-shi, Kyoto 612-8501 (JP); YAMAMOTO,Sentarou, Kyoto-shi, Kyoto 612-8501 (JP); OKAMOTO,Kazuhiro, Kyoto-shi, Kyoto 612-8501 (JP); OKAWA,Yoshihide, Kyoto-shi, Kyoto 612-8501 (JP)
(74) Representative: Viering, Jentschura & Partner mbB Patent- und Rechtsanwälte
(86) International application number: PCT/JP2020/040389
(87) International publication number: WO 2021/085458

(57) **Abstract**

A light emitting element mounting package includes a substrate and an insulating layer, the insulating layer is provided on a first surface of the substrate and has a through hole that penetrates in a direction perpendicular to the first surface, and a wall surface facing the through hole has a stepped portion, in which a diameter of the through hole is small on the side closer to the substrate and is large on the side far from the substrate.

## Description

### Technical Field

The present disclosure relates to a light emitting element mounting package and a light emitting device.

### Background Art

In recent years, light emitting diodes (LEDs) and laser diodes (LDs) have been used in headlamps of automobiles. Light source devices using these semiconductor elements are required to have high heat dissipation. Therefore, a metal substrate is used for the light source device (for example, see Patent Document 1).

### Citation List

### Patent Literature

Patent Document 1: JP 2013-38452

### Summary

A light emitting element mounting package of the present disclosure includes a substrate and an insulating layer. The insulating layer is provided on a first surface of the substrate, and includes a through hole that penetrates in a direction perpendicular to the first surface. The insulating layer has a stepped portion on an inner wall facing the through hole, in which a diameter of the through hole is small on the side closer to the substrate and is large on the side far from the substrate.

A light emitting device of the present disclosure includes a light emitting element on the substrate of the aforementioned light emitting element mounting package.

### Brief Description of Drawings

FIG. 1 is an external perspective view of a light emitting device illustrated as an example of an embodiment.
FIG. 2 is a cross-sectional view taken along line II-II in FIG. 1.
FIG. 3 is an external perspective view illustrating another aspect of a light emitting element mounting package.
FIG. 4 is a plan view of the light emitting element mounting package illustrated in FIG. 3.
FIG. 5 is a cross-sectional view taken along line V-V in FIG. 4.
FIG. 6 is a plan view illustrating a state immediately after a bonding material is applied in a through hole of the light emitting element mounting package illustrated in FIG. 4.
FIG. 7 is a cross-sectional view taken along line VII-VII in FIG. 6.
FIG. 8 is a plan view illustrating a state in the progress of installing a submount substrate together with a bonding material in the light emitting element mounting package illustrated in FIG. 4.
FIG. 9 is a cross-sectional view taken along the line IX-IX in FIG. 8.
FIG. 10 is a plan view illustrating a state when a submount substrate is installed together with a bonding material in the light emitting element mounting package illustrated in FIG. 4.
FIG. 11 is a cross-sectional view taken along the line XI-XI in FIG. 10.
FIG. 12 is a cross-sectional view illustrating another aspect of a light emitting element mounting package.
FIG. 13 is a cross-sectional view illustrating another aspect of a light emitting element mounting package.
FIG. 14 is a cross-sectional view illustrating another aspect of a light emitting element mounting package.
FIG. 15 is a cross-sectional view illustrating a method of manufacturing a light emitting device illustrated as an example of an embodiment.

### Description of Embodiments

For example, in the light emitting element mounting package disclosed in Patent Document 1, a ceramic substrate is used as a submount substrate. The submount substrate is bonded onto a metal substrate by using a bonding material such as solder. When the submount substrate is bonded onto the substrate by using the bonding material such as solder, the solder provided on the substrate may be deformed when it melts, and the submount substrate may be disposed in a state where it is not parallel to the substrate.

In the light emitting element mounting package, when the submount substrate is disposed in a state where it is not parallel to the substrate, the optical axis of a light emitting element mounted on the submount substrate may be deviated. A light emitting device with a deviated optical axis is determined to be defective as is, which leads to a decrease in manufacturing yield.

In this regard, the present disclosure provides a light emitting element mounting package in which a submount substrate can be disposed to be more parallel to a first surface of a substrate.

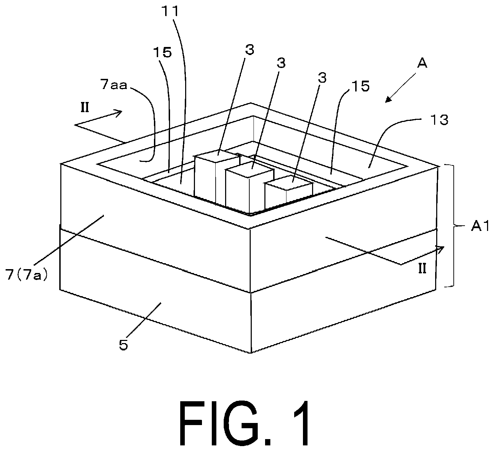

A light emitting element mounting package and a light emitting device of an embodiment will be described in detail below with reference to FIG. 1 to FIG. 15. In order to facilitate the understanding of functions of the light emitting element mounting package of the present disclosure, the following description will be given based on the structure of the light emitting device in which light emitting elements are mounted on the light emitting element mounting package.

Note that the present disclosure is not limited to the specific embodiments described below. Also, an aspect of the disclosure is assumed to include various aspects, provided that these aspects fall within the spirit or scope of the general inventive concepts as defined by the appended claims.

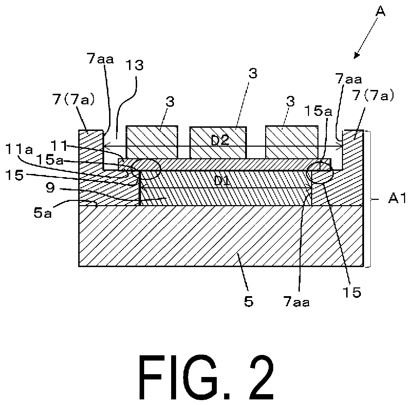

FIG. 1 is an external perspective view of a light emitting device illustrated as an example of an embodiment. FIG. 2 is a cross-sectional view taken along line II-II in FIG. 1.

A light emitting device A illustrated as an example of an embodiment includes a light emitting element mounting package A1 and light emitting elements 3. FIG. 1 and FIG. 2 illustrate a structure in which three light emitting elements 3 are mounted on the light emitting element mounting package A1. In this case, the number of light emitting elements 3 can be changed depending on the application of the light emitting device. For example, the number of light emitting elements 3 mounted on one light emitting element mounting package A1 is smaller than the number illustrated in FIG. 1 and FIG. 2. For example, a specification in which two or less light emitting elements 3 are mounted on one light emitting element mounting package A1 may be used. On the contrary, a specification in which four or more light emitting elements 3 are mounted on one light emitting element mounting package A1 may also be used. In this case, the number of light emitting elements 3 mounted on one light emitting element mounting package A1 depends on the size of the light emitting element 3; however, 100 may be set as a guide for the maximum number of light emitting elements 3.

The light emitting element mounting package A1 illustrated in FIG. 2 includes a bonding material 9 and a submount substrate 11 on a substrate 5. The light emitting elements 3 are mounted on the submount substrate 11. Examples of a method of mounting the light emitting elements 3 on the light emitting element mounting package A1 may include a flip chip method or a wire bonding method.

Examples of the light emitting element 3 may include a laser diode (LD) in addition to an LED. The light emitting element mounting package A1 includes the substrate 5 and an insulating layer 7. The insulating layer 7 is disposed on the substrate 5. The insulating layer 7 is disposed on a first surface 5a of the substrate 5. The insulating layer 7 includes a through hole 13 that penetrates in a thickness direction. The through hole 13 formed in the insulating layer 7 is in a state of penetrating in a direction perpendicular to the first surface 5a of the insulating layer 7. In the light emitting device A, the bonding material 9 is disposed to be in direct contact with the surface of the substrate 5. Heat is easily transferred from the light emitting elements 3 to the substrate 5 via the submount substrate 11 and the bonding material 9. The first surface 5a of the substrate 5 refers to a surface on which the insulating layer 7 is installed.

The insulating layer 7 has a structure in which a bank 7a is disposed on the substrate 5. In this case, when the substrate 5 is formed by four sides, the bank 7a means a portion along one side of the four sides. Accordingly, the aforementioned light emitting element mounting package A1 has a structure in which four banks 7a are assembled in a square shape. The insulating layer 7 has a cavity structure on the substrate 5.

The term "on the substrate 5"means not only a case of being directly in contact with the surface of the substrate 5 but also a case of being disposed on the surface of the substrate 5 via another member. The same applies to the following case written as "on".

As illustrated in FIG. 2, the bank 7a has a stepped portion 15 on an inner wall 7aa facing the through hole 13. The inner wall 7aa includes a surface of the stepped portion 15, which is perpendicular to the first surface 5a of the substrate 5. In FIG. 2, the stepped portion 15 is a portion indicated by ○. In the stepped portion 15, a portion corresponding to a so-called tread surface of a stair is hereinafter referred to as a shelf surface 15a. The stepped portion 15 is a portion including the shelf surface 15a and the inner wall 7aa.

In the bank 7a, the diameter of the through hole 13 is small on the side closer to the substrate 5 and is large on the side far from the substrate 5 when the shelf surface 15a is used as a boundary. In other words, the bank 7a has the stepped portion 15 on the inner wall 7a facing the through hole 13 due to the difference between the diameter of the through hole 13 closer to the substrate 5 and the diameter of the through hole 13 far from the substrate 5. In FIG. 2, the diameter of the through hole 13 on the side closer to the substrate 5 is set as a first diameter and is indicated by reference sign D1. The diameter of the through hole 13 on the side far from the substrate 5 is set as a second diameter and is indicated by reference sign D2. The first diameter D1 is smaller than the second diameter D2.

Due to the shape of the through hole 13, the bank 7a has a shape in which a frontage is larger on the side far from the substrate 5 than the substrate 5 side. As described above, in the light emitting element mounting package A1, the bank 7a has the stepped portion 15 as described above. Therefore, an end portion 11a of the submount substrate 11 can be disposed on the shelf surface 15a of the stepped portion 15. Accordingly, even when the submount substrate 11 is bonded onto the substrate 5 by using a bonding material such as solder, the submount substrate 11 can be disposed in a state parallel to the substrate 5 or a state close to parallel to the substrate 5.

The light emitting element mounting package A1 is more suitable when the bonding material 9 provided on the substrate 5 is melted and deformed. Furthermore, according to the light emitting device A, the light emitting element mounting package A1 with high position accuracy of the submount substrate 11 is used, which makes it possible to realize the light emitting device A having stable directivity and luminous intensity of emitted light.

The light emitting device A is illustrated only as an example of the embodiment. Another aspect of the light emitting element mounting package may include the following light emitting element mounting packages A2 to A5 in addition to the light emitting element mounting package A1.

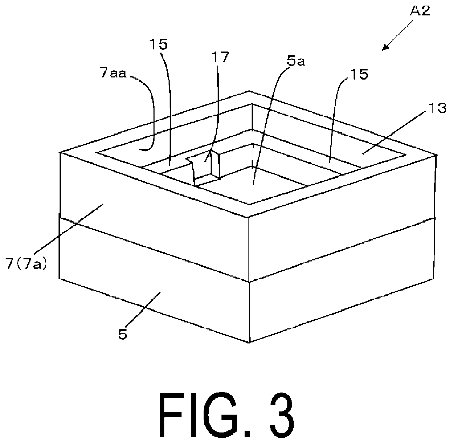

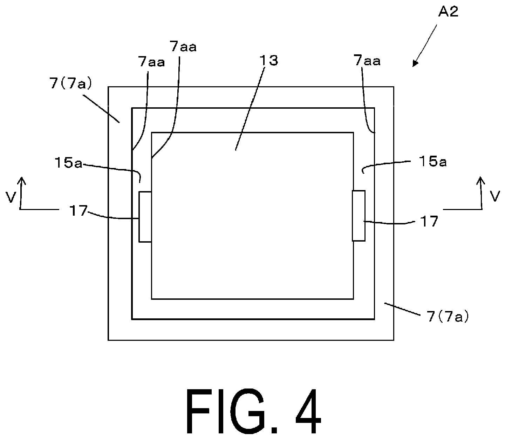

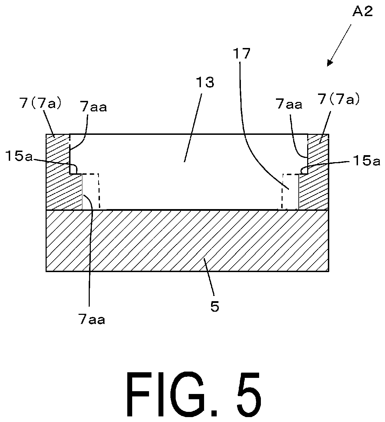

Next, as another aspect of the light emitting element mounting package A1, the light emitting element mounting package A2 in which recessed portions are provided in the wall surface 7aa of the bank 7a will be described. FIG. 3 is an external perspective view illustrating another aspect of a light emitting element mounting package. FIG. 4 is a plan view of the light emitting element mounting package illustrated in FIG. 3. FIG. 5 is a cross-sectional view taken along line V-V in FIG. 3.

The light emitting element mounting package A2 illustrated in FIG. 3 to FIG. 5 has recessed portions 17 in the bank 7a. The recessed portions 17 are provided in the inner wall 7aa of the bank 7a. The recessed portions 17 are provided in the inner wall 7aa of the bank 7a on the through hole 13 side. The recessed portions 17 are provided in the stepped portion 15 of the inner wall 7aa. The recessed portions 17 have the shape of a groove recessed in the direction of the thickness of the bank 7a. The groove forming the recessed portions 17 penetrates through the stepped portion 15. The bank 7a has the recessed portions 17 at a portion toward the substrate 5 from the stepped portion 15 of the inner wall 7aa.

The light emitting element mounting package A2 illustrated in FIG. 3 to FIG. 5 in the height direction of the bank 7a has a structure in which the recessed portions 17 are provided at two opposite positions of the bank 7a, but the positions of the recessed portions 17 are not limited thereto. The recessed portions 17 may be respectively provided in the four banks 7a provided in a square shape. A plurality of recessed portions 17 may be provided in one bank 7a. The shape of the recessed portion 17 is not limited to the shapes illustrated in FIG. 3 to FIG. 11. Hereinafter, for convenience, the shapes illustrated in FIG. 3 to FIG. 11 are represented as a space having a hexahedron shape, but any shape may be used as long as it can be filled with the bonding material 9. Preferably, the recessed portion 17 does not penetrate through the bank 7a in the direction of the thickness. The direction of the thickness of the bank 7a is a direction parallel to the first surface 5a of the substrate 5. According to the light emitting element mounting package A2, even when the through hole 13 is filled with an excessive amount of the bonding material 9, the bonding material 9 can be allowed to escape to the recessed portion 17. Accordingly, the submount substrate 11 can be installed on the shelf surface 15a of the bank 7a with high accuracy while improving the filling property of the bonding material 9 into the through hole 13. Therefore, the recessed portion 17 is preferably provided on the substrate 5 side rather than the shelf surface 15a of the bank 7a. In the light emitting element mounting package A2, the submount substrate 11 can be brought into close contact with the shelf surface 15a of the bank 7a, and the bonding material 9 can be filled with a high fill rate in a through hole on the side closer to the substrate 5 below the shelf surface 15a.

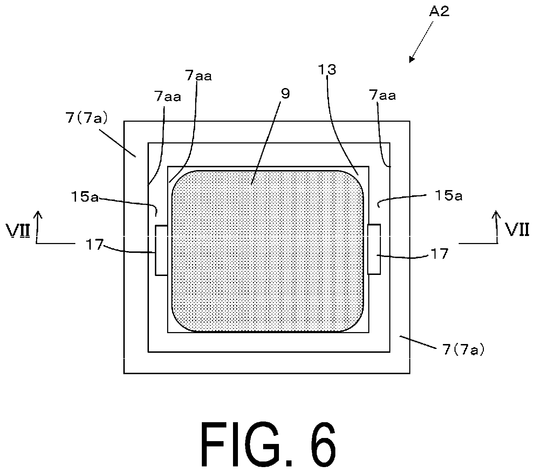

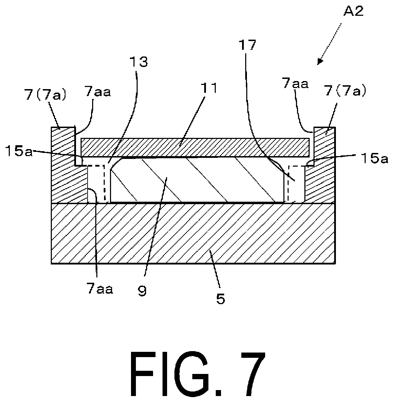

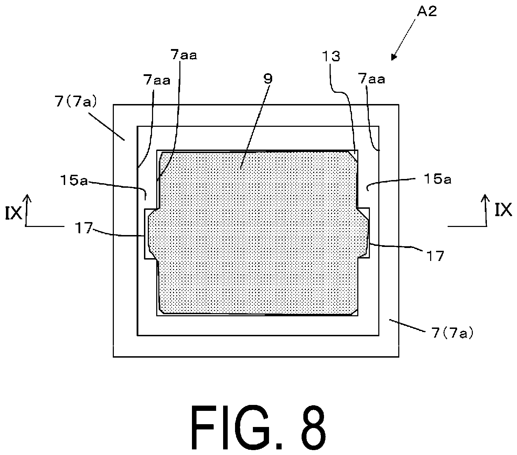

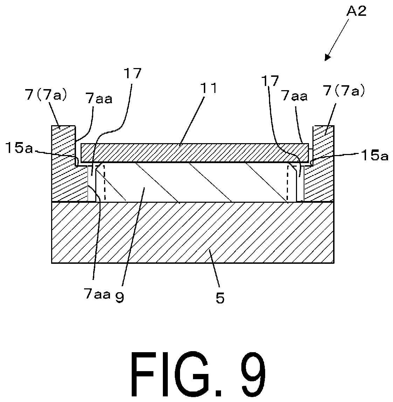

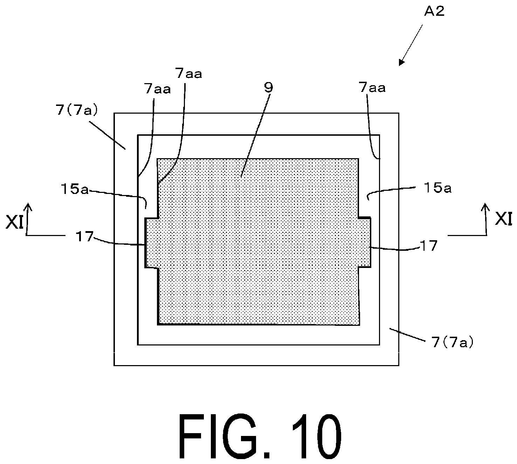

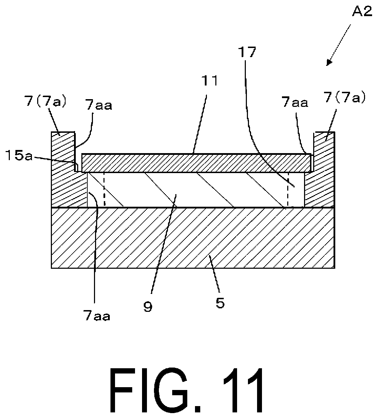

Subsequently, with reference to FIG. 6 to FIG. 11, a change in a state where the bonding material 9 is filled into the space of the through hole 13 including the recessed portions 17 and the submount substrate 11 is installed on the shelf surface 15a at the same time will be described. FIG. 6 and FIG. 7, FIG. 8 and FIG. 9, and FIG. 10 and FIG. 11 respectively illustrate a change from the states in FIG. 6 and FIG. 7, which are a pair of a plan view and a cross-sectional view of the light emitting element mounting package, to the states in FIG. 10 and FIG. 11 via the states in FIG. 8 and FIG. 9.

Details thereof are as follows. FIG. 6 is a plan view illustrating a state immediately after the bonding material 9 is applied to the through hole 13 of the light emitting element mounting package A2 illustrated in FIG. 4. FIG. 7 is a cross-sectional view illustrating a state immediately after the bonding material 9 is applied to the through hole 13 of the light emitting element mounting package A2 illustrated in FIG. 5. FIG. 8 is a plan view illustrating a state in the progress of installing the submount substrate 11 together with the bonding material 9 in the light emitting element mounting package A2 illustrated in FIG. 4. FIG. 9 is a cross-sectional view illustrating a state in the progress of installing the submount substrate 11 together with the bonding material 9 in the light emitting element mounting package A2 illustrated in FIG. 5. FIG. 10 is a plan view illustrating a state when the submount substrate 11 is installed together with the bonding material 9 in the light emitting element mounting package A2 illustrated in FIG. 4. FIG. 11 is a cross-sectional view illustrating a state when the submount substrate 11 is installed together with the bonding material 9 in the light emitting element mounting package A2 illustrated in FIG. 5.

FIG. 6 and FIG. 7 illustrate a state where the bonding material 9 is applied to the through hole 13 and the submount substrate 11 is placed on an upper surface of the bonding material 9. In other words, the bonding material 9 is located on the substrate 5 in the through hole 13. FIG. 8 and FIG. 9 illustrate a state where the bonding material 9 is softened or deformed within the through hole 13, and the submount substrate 11 is approaching the shelf surface 7aa. FIG. 10 and FIG. 11 illustrate a state where the submount substrate 11 is in contact with the shelf surface 7aa, and at the same time, the bonding material 9 is filled in the through hole 13 including the recessed portions 17. In other words, the submount substrate 11 is located on the stepped portion 15 in the through hole 13.

As can be seen from FIG. 6 to FIG. 11, when the recessed portion 17 is formed in the bank 7a, as the submount substrate 11 approaches the shelf surface 7aa of the bank 7a, the bonding material 9 spreads in the recessed portion 17 as well as the through hole 13. In this way, the bonding material 9 can sufficiently fill the through hole 13, and simultaneously can spread over the entire space of the through hole 13, which makes it possible to increase an area ratio in which the bonding material 9 is applied to the back surface of the submount substrate 11. Furthermore, the submount substrate 11 can be accurately installed on the shelf surface 7aa of the bank 7a.

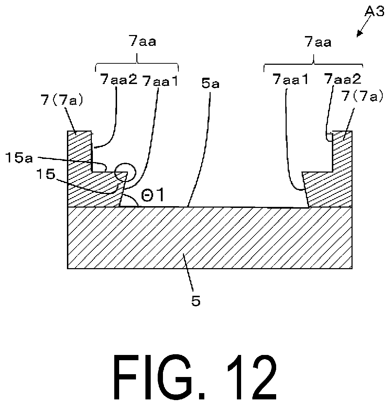

FIG. 12 is a cross-sectional view illustrating another aspect of a light emitting element mounting package. Hereinafter, the inner wall 7as is described as follows. First, an inner wall on the side closer to the substrate 5 is referred to as a lower inner wall 7aa1 when the shelf surface 15a is used as a boundary. An inner wall on the side far from the substrate 5 is referred to as an upper inner wall 7aa2 when the shelf surface 15a is used as a boundary.

In a light emitting element mounting package A3 illustrated in FIG. 12, the lower inner wall 7aa1 of the bank 7a is inclined with respect to the first surface 5a located on the through hole 13 of the substrate 5. The lower inner wall 7aa1 is preferably inclined so that an angle θ1 of the substrate 5 with respect to the first surface 5a is an acute angle. In a case where the light emitting element mounting package A3 has a structure in which the lower inner wall 7aa1 of the bank 7a is inclined at an acute angle with respect to the first surface 5a of the substrate 5, when the bonding material 9 is applied to the substrate 5, the bonding material 9 is pressed from the side surface to the inclined wall surface 7aa1. This makes it difficult for the bonding material 9 to peel off from the substrate 5. As a consequence, the life and reliability of the light emitting element mounting package A3 and a light emitting device produced by using the light emitting element mounting package A3 can be enhanced.

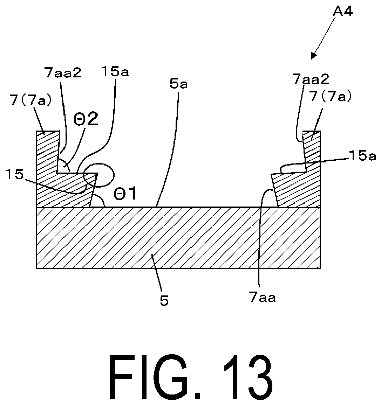

FIG. 13 is a cross-sectional view illustrating another aspect of a light emitting element mounting package. In a light emitting element mounting package A4 illustrated in FIG. 13, when the shelf surface 15a is used as a boundary within the bank 7a, the upper inner wall 7aa2, which is an inner wall on the side far from the substrate 5, is inclined with respect to the first surface 5a located on the through hole 13 side of the substrate 5.

The upper inner wall 7aa2 is also preferably inclined so that the angle θ1 of the substrate 5 located on the through hole 13 side with respect to the first surface 5a is an acute angle. When the upper inner wall 7aa2 of the bank 7a is inclined at an acute angle with respect to the first surface 5a of the substrate 5, the submount substrate 11 is easily fixed between the banks 7a. Even when the length (or width) of the submount substrate 11 is shorter than the diameter D2 of the through hole 13, the submount substrate 11 is less likely to come out from the through hole 13 surrounded by the banks 7a. As a consequence, the reliability such as the life of the light emitting element mounting package A4 and a light emitting device produced by using the light emitting element mounting package A4 can be enhanced.

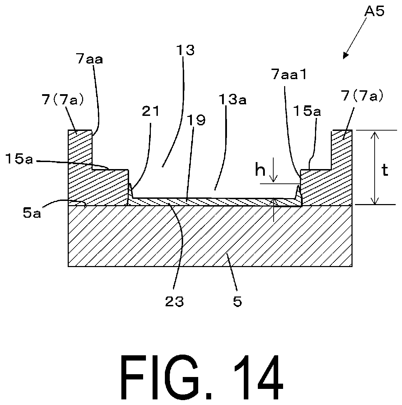

FIG. 14 is a cross-sectional view illustrating another aspect of a light emitting element mounting package. A light emitting element mounting package A5 illustrated in FIG. 14 has a metal layer 19. The metal layer 19 is disposed on the substrate 5. The metal layer 19 is disposed in at least the through hole 13 on the substrate 5. In other words, the metal layer 19 is located on the substrate 5 in the through hole 13. In this case, the metal layer 19 may be provided on the entire surface of the first surface 5a of the substrate 5. The metal layer 19 is disposed on the substrate 1 so as to occupy a region inside the through hole 13. In other words, the metal layer 19 includes a portion on the substrate 5, which occupies at least a region inside the through hole 13.

Furthermore, the metal layer 19 includes a portion extending from the substrate 5 to the wall surface 7aa1 of the bank 7a on the through hole 13 side. Of the metal layer 19, a portion extending from the substrate 5 to the wall surface 7aa1 is referred to as a protruding portion 21. Of the metal layer 19, a portion excluding the protruding portion 21 is referred to as a flat portion 23. The protruding portion 21 is provided at an end of the flat portion 23. The protruding portion 21 is a portion above a surface of the flat portion 23. In this case, the protruding portion 21 has a structure that is continuously connected from the flat portion 23.

As illustrated in FIG. 14, in the light emitting element mounting package A5, the protruding portion 21, which is a part of the metal layer 19, is provided so as to adhere to the wall surface 7aa1 of the bank 7a. When the metal layer 19 has a shape provided with the protruding portion 21, the bank 7a can be prevented from moving to a center portion 13a of the through hole 13 by thermal expansion. In other words, the protruding portion 21 plays a role in preventing the movement of the bank 7a on the substrate 5. Since the protruding portion 21 is provided so as to adhere to the lower inner wall 7aa1 of the through hole 13, it becomes difficult for the bank 7a to move on the substrate 5 in a direction along the first surface 5a of the substrate 5. The protruding portion 21 can reduce deformation between the substrate 5 and the bank 7a. This makes it difficult for the bank 7a (insulating layer 7) to peel off from the substrate 5.

In this case, the protruding portion 21 is preferably provided so as to be annularly arranged along the lower inner wall 7aa1 of the bank 7a disposed in a square shape. In other words, the protruding portion 21 may have a wall-like structure surrounding the through hole 13. The wall-like structure surrounding the through hole 13 refers to a state where the protruding portion 21 is formed around the entire lower inner wall 7aa1 of the bank 7a. When the protruding portion 21 is provided so as to be annularly arranged along the lower inner wall 7aa1, the bank 7a can be prevented from moving on the substrate 5 toward the center of the through hole 13 from the entire circumference of the through hole 13. In this case, as illustrated in FIG. 14, the protruding portion 21 has a predetermined value or more of height h capable of stopping the movement of the insulating layer 3 toward the center direction of the through hole 7. The height h of the protruding portion 21 is within the range of the height of the lower inner wall 7aa1.

Furthermore, the protruding portion 21 may be formed by a connection body of metal particles. A structure in which the metal particles are connected refers to a structure in which a plurality of metal particles are connected at a portion smaller than the size of the metal particles. The structure in which the metal particles are connected may be hereinafter referred to as a connection body. Furthermore, a portion smaller than the size of the metal particles may be referred to as a neck portion. When the protruding portion 21 is formed by the connection body of the metal particles, the surface of the protruding portion 21 is uneven. The surface of the protruding portion 21 has an uneven shape. When the protruding portion 21 has a structure of the connection body, the protruding portion 21 has a neck portion, so that the protruding portion 21 is more easily deformed than a film-like structure such as the metal layer 19. Therefore, even when the protruding portion 21 is connected to the flat portion 6 of the metal layer 19 and bonded to the insulating layer 3, the protruding portion 11 is not easily destroyed. When the protruding portion 21 has a structure of the connection body, even though there is deformation caused by a difference in thermal expansion coefficients between the metal layer 19 and the insulating layer 7, the protruding portion 21 easily follows the deformation. As a consequence, the protruding portion 21 is difficult to peel off from the wall surface 7aa1 of the bank 7a. Since the insulating layer 7 (bank 7a) is difficult to peel off from the metal layer 19 including the protruding portion 21, the insulating layer 7 is difficult to peel off from the substrate 5.

In this case, the substrate 5 is preferably made of a metal. The material of the substrate 5 is preferably at least one selected from the group consisting of aluminum, zinc, copper, and the like. Of these materials, when a light emitting element mounting package is applied to, for example, a headlamp of an automobile, aluminum is suitable because it is lightweight and has high oxidation resistance. A clad material in which copper and aluminum are layered is preferable from the viewpoint that the warpage of a substrate can be reduced. This cladding material is also suitable in terms of heat dissipation.

The insulating layer 7 is preferably made of an organic resin. The material of the organic resin is preferably at least one selected from the group consisting of phenol resin, amino resin, urea resin, maleimide resin, polyester resin, and epoxy resin. Of these materials, epoxy resin is suitable because it has high heat resistance, high mechanical strength, and is relatively inexpensive. The insulating layer 7 may include an inorganic filler. When the insulating layer 7 is configured to include an inorganic filler, the mechanical strength of the insulating layer 7 can be further increased. When the insulating layer 7 is configured to include an inorganic filler, the thermal expansion coefficient of the insulating layer 7 can be reduced. When the insulating layer 7 is configured to include an inorganic filler, the thermal expansion coefficient of the insulating layer 7 can be made close to the thermal expansion coefficient of the substrate 5.

As the material of the inorganic filler, at least one selected from the group consisting of silica, alumina, mullite, glass, and the like is suitable. Of these materials, silica is preferable in terms of employing a material having a small particle size and a uniform particle size.

As the submount substrate 11, a high-strength ceramic such as silicon nitride, aluminum nitride, and alumina is suitable. When the light emitting elements 3 are mounted on the submount substrate 11 and emit light, the temperature of the light emitting element mounting package rises above normal temperature. In such a case, the width of the submount substrate 11 is preferably smaller than the second diameter D2 of the through hole 13. Even though the insulating layer 7 is deformed due to thermal expansion or the like, the submount substrate 11 is not easily affected by the deformation of the insulating layer 7.

The metal layer 19 is preferably at least one selected from the group consisting of zinc, nickel, copper, palladium, and gold. The metal layer 19 may have a structure in which these materials (components) overlap in a layered shape. For the analysis of the metal layer 19, for example, a scanning electron microscope provided with an analyzer is preferably used. A scanning electron microscope is preferably used for measuring the average thickness of the metal layer 19 and the height and thickness of the protruding portion 21. The bonding material 9 is preferably one selected from the group consisting of Au-Sn, silver solder, solder, organic resin, organic resin containing metal particles such as Ag and Cu, and the like.

The light emitting element mounting packages A1 to A5 described above can also be applied to a structure in which a plurality of through holes 13 are formed in one insulating layer 7. In this case, the bonding material 9, the submount substrate 11, and the light emitting elements 3 are preferably disposed in each of the through holes 13. Moreover, a structure in which a plurality of the bonding materials 9, a plurality of the submount substrates 11, and a plurality of the light emitting elements 3 are disposed in one through hole 13 may be used.

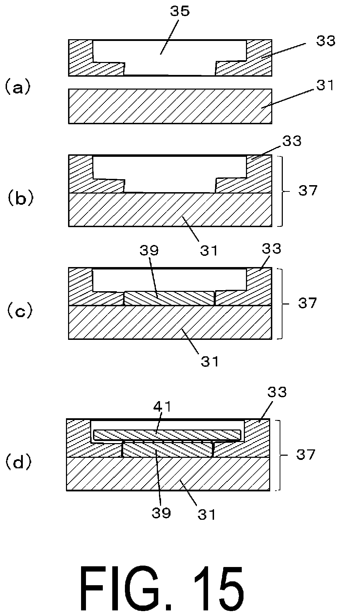

FIG. 15 is a cross-sectional view illustrating a method of manufacturing a light emitting device illustrated as an example of an embodiment. The method of manufacturing the light emitting device illustrated in FIG. 15 is an example of the light emitting device A illustrated in FIG. 1 and FIG. 2. As illustrated in FIG. 15(a), first, a metal plate 31 and an organic resin sheet 33 are prepared. The metal plate 31 is a material for obtaining the substrate 5. The organic resin sheet 33 is a material for obtaining the insulating layer 7. The organic resin sheet 33 is hereinafter referred to as a resin sheet 33.

As illustrated in FIG. 15(a), the metal plate 31 and the resin sheet 33 are each machined into a predetermined shape. The resin sheet 33 has a hole 35 that later becomes the through hole 13 of the insulating layer 7. In order to form the hole 35, a laser beam machine can be used in addition to a mold. The metal plate 31 is machined into the shape of the substrate 1. It is preferable to use a mechanical cutting machine such as dicing in order to machine the metal plate 31. When the metal plate 31 is machined by using a mechanical cutting machine, unevenness is easily formed on the surface of the obtained metal plate 31. The unevenness formed on the surface of the metal plate 31 enables the resin sheet 33 to be firmly adhered to the surface of the metal plate 31.

Next, as illustrated in FIG. 15(b), the resin sheet 33 is bonded to the first surface 5a side of the metal plate 31 to produce a laminated body 37. For bonding between the metal plate 31 and the resin sheet 33, a laminating machine capable of pressurizing in a heated state is used. At this time, in the case of obtaining the light emitting element mounting packages A3 and A4 in which the lower inner wall 7aa1 and the upper inner wall 7aa2 of the bank 7a are inclined, the pressurized heating condition may be such that the cross section of a through hole 35 formed in the resin sheet 33 is deformed. In the case of obtaining the structures of the light emitting element mounting packages A3 and A4, when the resin sheet 33 is bonded onto the metal plate 31, the fact that a bonding surface between the metal plate 1 and the resin sheet 33 is less likely to move, but the other portions in the thickness direction away from the bonding surface are easily deformed thermoplastically, is used.

Next, as illustrated in FIG. 15(c), a bonding material 39 is applied to a first surface of the metal plate 31 in the through hole 35. In this case, the metal layer 19 may be formed on the first surface of the metal plate 31 to which the bonding material 39 is applied. The metal layer 19 preferably has the protruding portion 21.

Next, as illustrated in FIG. 15(d), a submount substrate 41 is disposed on the bonding material 39 provided in the through hole 35. At this time, in the step in FIG. 15(d), the submount substrate 41 may be pressed from above while melting the bonding material 39. Next, the light emitting elements 3 are mounted on the submount substrate 41 installed in the through hole 35. By so doing, the light emitting device A can be obtained. Although the light emitting element mounting package A1 has been described as an example in FIG. 15, the other light emitting element mounting packages A2 to A5 described above can be obtained by the same manufacturing method.

### Examples

A light emitting element mounting package was actually produced and evaluated for reliability. Using the manufacturing method described above, light emitting element mounting packages A1, A2, A4-1, A4-2, A5-1, and A5-2 were produced. A4-1 denotes the light emitting element mounting package A4 illustrated in FIG. 13. A4-2 denotes a light emitting element mounting package in which recessed portions are provided on a wall surface of a bank of the light emitting element mounting package A4 illustrated in FIG. 13. The positions of the recessed portions provided in a light emitting element mounting package of the sample A4-2 are the same as those of the light emitting element mounting package A2. That is, there are two recessed portions. The two recessed portions were disposed to face each other as illustrated in FIG. 4. A5-1 denotes the light emitting element mounting package A5 illustrated in FIG. 14. A5-2 denotes a light emitting element mounting package in which recessed portions are provided on a wall surface of a bank of the light emitting element mounting package A5 illustrated in FIG. 14. The positions of the recessed portions provided in the light emitting element mounting package A5-2 are the same as those of the light emitting element mounting package A2. That is, also in this case, there are two recessed portions. The two recessed portions were disposed at the positions of banks facing each other as illustrated in FIG. 4.

Aluminum was used as the substrate. An epoxy resin containing 30% by volume of silica particles was used as the insulating layer. A shelf surface of a stepped portion formed in the insulating layer was machined to be parallel to the first surface of the insulating layer. The through hole was formed using a mold. The metal layer was formed by an electrolytic plating method using a plating solution of nickel containing zinc. The following conditions were used for pressurized heating when producing the laminated body. The conditions for producing the structures of the light emitting element mounting packages A1, A2, and A5 were a temperature of 80°C and a pressure of 5 MPa. The laminated body that was subjected to pressurized heating was then subjected to heat treatment at a temperature of 200°C for a holding time of 3 hours.

The conditions for producing the structure of the light emitting element mounting package A4 were a temperature of 80°C and a pressure of 6 MPa. The laminated body that was subjected to pressurized heating was then subjected to heat treatment at a temperature of 200°C for a holding time of 3 hours. Furthermore, a so-called light emitting element mounting package having no stepped portion on the wall surface of the through hole formed in the insulating layer and having the same diameter in the thickness direction of the through hole was produced as a Comparative Example (sample 7).

The following setting was used as the basic size for the produced light emitting element mounting package. The area of a plane of the substrate and the insulating layer was 40 mm × 40 mm, and the shape of the through hole provided in the insulating layer was square when viewed in plan view. Furthermore, the area of the through hole was 20 mm × 20 mm on a first diameter side and 25 mm × 25 mm on a second diameter side. The area of the through hole of the sample 7 was 20 mm × 20 mm. The thickness of the substrate and the insulating layer was 1 mm.

The position of the step portion (shelf surface) of the insulating layer in the thickness direction was set to a position in the middle of the thickness of the insulating layer. The diameter of a through hole having no stepped portion was 20 mm × 20 mm. Eutectic solder was used for the bonding material. The bonding material was applied on the substrate so as to have a mountain shape. The top of the bonding material was set to be approximately 0.1 mm higher above the position of the shelf surface formed on the wall surface of the bank.

A silicon nitride substrate was used as the submount substrate. On the submount substrate, a copper metallized layer and a nickel plating film were formed on a surface in contact with the bonding material. For the submount substrate, the surface on which the copper metallized layer and the nickel plating film were formed was set to the bonding material side. The size of the submount substrate was 23 mm × 23 mm × 0.2 mm. For the sample 7, a submount substrate having a size of 18 mm × 18 mm × 0.2 mm was used.

The following evaluations were performed on the produced sample. The evaluation items indicate parallelism of the submount substrate with respect to the substrate, the ratio of voids formed in the through hole, and the adhesion between the submount substrate and the bonding material. The parallelism of the submount substrate with respect to the substrate (metal plate) was measured using a digital microscope capable of measuring the dimension of the cross section of the sample. The dimension between the surface of the submount substrate on the bonding material side and the surface of the substrate (metal plate) on the bonding material side was measured. The measured positions are two points at both ends of the submount substrate. The length of a perpendicular line virtually extended from the substrate (metal plate) to the submount substrate side was measured. The dimensional difference between the two measured points was set as parallelism. The smaller the dimensional difference, the higher the parallelism. The cross-section of the sample was also evaluated with a digital microscope for the ratio of voids formed in the through hole. A region between the submount substrate and the substrate (metal plate) was used as a reference cross-sectional area of the through hole. The ratio of the voids to the area of the cross section of the through hole was calculated. For a sample with recessed portions in the bank, an area excluding the recessed portions was used as a reference area of the through hole.

The adhesion between the submount substrate and the bonding material was evaluated by the following reliability test. A temperature cycle test was used as the reliability test. The conditions for the temperature cycle test were that the minimum temperature was -55°C, the maximum temperature was 150°C, and the holding time at the minimum temperature, the holding time at the maximum temperature, and the time for changing the temperature from the minimum temperature to the maximum temperature or vice versa were each 15 minutes. The number of temperature cycles was set to 3,000. The number of samples was 10 of each. In the evaluation after the test, pass/fail was determined based on whether there is a peeled portion between the submount substrate and the bonding material.

The state of peeling between the submount substrate and the bonding material was confirmed by a method of immersing in a red check liquid. Samples in which the red check liquid had penetrated between the submount substrate and the bonding material were determined to be defective. At the same time, the penetration of the red check liquid between the substrate and the insulating layer was also evaluated. The parallelism of the submount substrate with respect to the substrate and the ratio of the voids formed in the through hole were written in Table 1 below by calculating average values. Regarding the adhesion between the submount substrate and the bonding material, the adhesion was determined to be present when observed in even one of 10 samples.

**[Table 1]**

| Sample | Structure of light emitting element mounting package | Parallelism of submount substrate with respect to substrate | Ratio of voids formed in through hole | Adhesion between submount substrate and bonding material (presence or absence of red check liquid) |
|---|---|---|---|---|
| | | µm | % | Present or Absent |
| Sample 1 | A1 | 9 | 7 | Present |
| Sample 2 | A2 | 4 | 2 | Absent |
| Sample 3 | A4-1 | 9 | 6 | Present |
| Sample 4 | A4-2 | 4 | 1 | Absent |
| Sample 5 | A5-1 | 9 | 6 | Present |
| Sample 6 | A5-2 | 4 | 1 | Absent |
| Sample 7 | No stepped portion | 15 | 6 | Present |

As can be seen from the results in Table 1, in the sample (sample 7) having no stepped portion on the wall surface facing the through hole, a value of 15 µm was evaluated as the parallelism of the submount substrate with respect to the substrate. In the samples (sample 1 to sample 6) having the stepped portion on the wall surface facing the through hole, a value of 9 µm or less was evaluated as the parallelism of the submount substrate with respect to the substrate. Of these samples, in the samples (sample 2, sample 4, and sample 6) having the recessed portions on the wall surface of the bank, the ratio of the voids formed in the through hole was 2% or less. The sample 2, the sample 4, and the sample 6 exhibited high adhesion with no penetration of the red check liquid between the submount substrate and the bonding material. At the same time, the penetration of the red check liquid between the substrate and the insulating layer was also evaluated. In the sample 1 to the sample 4, the penetration of the red check liquid between the substrate and the insulating layer was slightly confirmed, but not in the sample 5 and sample 6.

### Reference Signs List

1 Light emitting element mounting package
3 Light emitting element
5 Substrate
5a First surface (of substrate)
7 Insulating layer
7a Bank
7aa, 7aa1, 7aa2 Wall surface
9 Bonding material
11 Submount substrate
13 Through hole
13a Center portion (of through hole)
15 Stepped portion
17 Recessed portion
19 Metal layer
21 Protruding portion

## Claims

1. A light emitting element mounting package comprising:
a substrate; and
an insulating layer, wherein
the insulating layer is provided on a first surface of the substrate and has a through hole that penetrates in a direction perpendicular to the first surface, and an inner wall facing the through hole comprises a stepped portion due to a difference between a diameter of the through hole closer to the substrate and a diameter of the through hole far from the substrate.

2. The light emitting element mounting package according to claim 1, wherein
the insulating layer comprises a recessed portion at a portion toward the substrate from the stepped portion of the inner wall.

3. The light emitting element mounting package according to claim 1 or 2, wherein
the inner wall has an acute angle with the first surface.

4. The light emitting element mounting package according to any one of claims 1 to 3, wherein
a metal layer is located on the substrate in the through hole, and comprises a protruding portion that protrudes from the substrate along the inner wall.

5. The light emitting element mounting package according to any one of claims 1 to 4, wherein
a bonding material is located on the substrate in the through hole.

6. The light emitting element mounting package according to any one of claims 1 to 5, wherein
a submount substrate is located on the stepped portion in the through hole.

7. A light emitting device comprising:
a light emitting element on the substrate of the light emitting element mounting package according to any one of claims 1 to 6.
